(19) Europäisches Patentamt
European Patent Office
Office européen des brevets

(11) EP 2 841 476 B1

(12) # FASCICULE DE BREVET EUROPEEN

(45) Date de publication et mention de la délivrance du brevet:
**08.06.2016 Bulletin 2016/23**

(21) Numéro de dépôt: **13723869.7**

(22) Date de dépôt: **25.04.2013**

(51) Int Cl.:
***C08F 255/02*** (2006.01) ***C08G 81/02*** (2006.01)
***C08L 51/06*** (2006.01) ***H01L 31/048*** (2006.01)
***C08L 23/00*** (2006.01) ***C08L 77/00*** (2006.01)
***C08J 5/18*** (2006.01) ***C08L 77/02*** (2006.01)
***C08L 87/00*** (2006.01)

(86) Numéro de dépôt international:
**PCT/FR2013/050919**

(87) Numéro de publication internationale:
**WO 2013/160620 (31.10.2013 Gazette 2013/44)**

(54) **COMPOSITION THERMOPLASTIQUE PRESENTANT UN TAUX DE GREFFAGE POLYAMIDE ELEVE**

THERMOPLASTISCHE ZUSAMMENSETZUNG MIT HOHER POLYAMIDPFROPFUNGSRATE

THERMOPLASTIC COMPOSITION HAVING A HIGH POLYAMIDE GRAFTING RATE

(84) Etats contractants désignés:
**AL AT BE BG CH CY CZ DE DK EE ES FI FR GB GR HR HU IE IS IT LI LT LU LV MC MK MT NL NO PL PT RO RS SE SI SK SM TR**

(30) Priorité: **26.04.2012 FR 1253839**

(43) Date de publication de la demande:
**04.03.2015 Bulletin 2015/10**

(73) Titulaire: **Arkema France**
**92700 Colombes (FR)**

(72) Inventeurs:
- **JOUSSET, Dominique**
**F-78380 Bougival (FR)**
- **FLAT, Jean-Jacques**
**F-27170 Goupillieres (FR)**
- **DEVISME, Samuel**
**F-76000 Rouen (FR)**
- **FINE, Thomas**
**F-69007 Lyon (FR)**
- **BIZET, Stéphane**
**F-27170 Barc (FR)**

(74) Mandataire: **Gavin, Pablo et al**
**Arkema France**
**Département Propriété Industrielle**
**420, rue d'Estienne d'Orves**
**92705 Colombes Cedex (FR)**

(56) Documents cités:
**EP-A1- 2 196 489** **FR-A1- 2 291 225**
**FR-A1- 2 930 556** **US-A- 3 976 720**

Il est rappelé que: Dans un délai de neuf mois à compter de la publication de la mention de la délivrance du brevet européen au Bulletin européen des brevets, toute personne peut faire opposition à ce brevet auprès de l'Office européen des brevets, conformément au règlement d'exécution. L'opposition n'est réputée formée qu'après le paiement de la taxe d'opposition. (Art. 99(1) Convention sur le brevet européen).

EP 2 841 476 B1

## Description

### Domaine de l'invention

L'invention a pour objet une composition thermoplastique comprenant une polyoléfine greffée polyamide dont le taux de greffage polyamide est élevé. La présente invention concerne également l'utilisation de cette composition dans un module photovoltaïque, plus précisément dans une ou plusieurs des couches formant un tel module, plus particulièrement dans la couche formant encapsulant.

Le réchauffement climatique, lié aux gaz à effet de serre dégagés par les énergies fossiles, a mené au développement de solutions énergétiques alternatives qui n'émettent pas de tels gaz lors de leur fonctionnement, comme par exemple les modules photovoltaïques. Un module photovoltaïque comprend une « pile photovoltaïque », cette pile étant capable de transformer l'énergie lumineuse en électricité.

Il existe de nombreux types de structures de panneaux photovoltaïques.

Sur la Figure 1, on a représenté une pile photovoltaïque classique ; cette pile photovoltaïque 10 comprend des cellules 12, une cellule contenant un capteur photovoltaïque 14, généralement à base de silicium traité afin d'obtenir des propriétés photoélectriques, en contact avec des collecteurs d'électrons 16 placés au-dessus (collecteurs supérieurs) et au-dessous (collecteurs inférieurs) du capteur photovoltaïque. Les collecteurs 16 supérieurs d'une cellule sont reliés aux collecteurs 16 inférieurs d'une autre cellule 12 par des barres conductrices 18, constituées généralement d'un alliage de métaux. Toutes ces cellules 12 sont connectées entre elles, en série et/ou en parallèle, pour former la pile photovoltaïque 10. Lorsque la pile photovoltaïque 10 est placée sous une source lumineuse, elle délivre un courant électrique continu, qui peut être récupéré aux bornes 19 de la pile 10.

En référence à la Figure 2, le module photovoltaïque 20 comprend la pile photovoltaïque 10 de la Figure 1 enrobée dans un « encapsulant », celui-ci étant composé d'une partie supérieure et d'une partie inférieure. Une couche protectrice supérieure 24 (connue en anglais sous le terme « frontsheet », utilisé dans la suite) et une couche protectrice au dos du module (connue en anglais sous le terme « backsheet », également utilisé dans la suite) 26 sont disposées de part et d'autre la pile encapsulée.

La protection au choc et à l'humidité de la pile photovoltaïque 10 est assurée par la couche protectrice supérieure 24, généralement en verre.

Le backsheet 26 contribue à la protection à l'humidité du module photovoltaïque 20 et à l'isolation électrique des cellules 12 pour éviter tout contact avec l'environnement extérieur.

L'encapsulant 22 doit épouser parfaitement la forme de l'espace existant entre la pile photovoltaïque 10 et les couches protectrices 24 et 26 afin d'éviter la présence d'air, ce qui limiterait le rendement du module photovoltaïque. L'encapsulant 22 doit également empêcher le contact des cellules 12 avec l'eau et l'oxygène de l'air, afin d'en limiter la corrosion. La partie supérieure de l'encapsulant 22 est comprise entre la pile 10 et la couche protectrice supérieure 24. La partie inférieure de l'encapsulant 22 est comprise entre la pile 10 et le backsheet 26.

En présence de rayonnement solaire, il se crée un échauffement à l'intérieur du module solaire et des températures de 80°C (ou plus) peuvent être atteintes ce qui nécessite que les couches soient parfaitement liées les unes aux autres tout au long du cycle de vie du module.

### Etat de l'art

A l'heure actuelle, on connaît dans le domaine des modules photovoltaïques des compositions particulièrement intéressantes au regard de leurs qualités thermomécaniques car incluant des polyoléfines greffées polyamides jusqu'à 40% de greffons de polyamide en poids.

Cette limite de 40% de greffons polyamide n'a jamais été franchie. Ainsi, on connait les documents de la demanderesse FR 2918150 ou EP 2196489 qui divulguent des compositions à base de polyoléfine greffé polyamide dans lesquelles la masse de polyamide est comprise entre 15% et 30% et atteint jusqu'à 39,5% de la composition. Ces documents revendiquent parfois de telles compositions avec des masses de polyamide greffé supérieur mais aucun exemple de telle composition n'est donné et n'a jamais été réalisé, considérant les inconvénients de ces taux de polyamide greffé.

L'homme du métier sait en effet qu'au-delà de cette limite, les greffons de polyamide vont augmenter très sensiblement la viscosité, c'est-à-dire que le MFI (« Melt Flow Index ») va diminuer jusqu'à une valeur proche de 0, ce qui va rendre en particulier le procédé de préparation de la composition totalement impossible.

Par ailleurs, l'homme du métier sait que l'augmentation de polyamide dans la composition aura une incidence négative sur la transparence de la composition, ce qui rend cette dernière impropre à être utilisée dans des applications où la transparence de la composition est recherchée voire nécessaire, notamment dans le domaine du photovoltaïque pour les couches de « frontsheet » et surtout pour la couche d'encapsulant.

**Brève description de l'invention**

Il a été constaté par la demanderesse, après diverses expériences et manipulations, que, contrairement aux enseignements bien connues de l'homme du métier, une composition polyoléfine contenant un taux de greffage de polyamide compris entre 41% et 70% en poids de la composition présentait un intérêt technique majeur.

Ainsi, en choisissant de façon appropriée le polyamide à greffer sur le tronc de polyoléfine, une telle composition comportant des greffons de polyamide à un taux compris entre 41% et 70% en poids présente un MFI, certes bas mais stable voire qui augmente pour les fort taux de polyamide, ainsi qu'une transparence stable voire améliorée par rapport aux mêmes compositions contenant un taux de polyamide greffé inférieur ; étant entendu par ailleurs que la composition selon l'invention présente la particularité d'être nanostructuré.

Par ailleurs, il a été constaté par la demanderesse qu'une telle composition diluée dans une polyoléfine présente, contrairement à ce qui pouvait être anticipé, par rapport à une composition identique présentant des taux de polyamide exactement similaire (mais non issu d'une polyoléfine greffé polyamide ayant une masse de polyamide compris entre 41% et 70%, c'est-à-dire une masse de polyamide inférieure à ce domaine 41%-70%) soit une résistance au fluage supérieure soit une résistance au fluage équivalente et une fluidité plus importante permettant de faciliter la mise en oeuvre de ladite composition. L'alternative entre les propriétés obtenues est fonction du taux de greffage de polyamide, autrement dit la masse de polyamide greffé par rapport à celle de la composition ; étant considéré que la résistance plus importante au fluage est obtenue pour une masse de polyamide greffé comprise entre 41% et 55% de la composition tandis que la stabilisation de la caractéristique de fluage, tout en ayant une fluidité plus importante, est obtenu pour une masse de polyamide greffé comprise entre 55% et 70% en poids de la composition.

Ainsi, la présente invention concerne une composition thermoplastique comprenant un tronc en polyoléfine contenant un reste d'au moins un monomère insaturé X et une pluralité de greffons en polyamide, dans lequel :

- les greffons en polyamide sont attachés au tronc en polyoléfine par le reste du monomère insaturé X comprenant une fonction capable de réagir par une réaction de condensation avec un polyamide ayant au moins une extrémité amine et/ou au moins une extrémité acide carboxylique,
- le reste du monomère insaturé X est fixé sur le tronc par greffage ou copolymérisation,

caractérisé en ce que les greffons en polyamide représente de 41% à 70%, de préférence entre 45% et 70%, en masse dudit polymère greffé polyamide.

D'autres caractéristiques avantageuses de l'invention sont précisées dans la suite :

Avantageusement, le susdit polymère greffé est nanostructuré.

Selon une particularité de l'invention, la masse molaire en nombre des susdits greffons polyamide du susdit polymère greffé est comprise dans la gamme allant de 1000 à 10000 g/mol.

De même, pour les susdits polymères greffés, le nombre de monomère X fixé sur le tronc en polyoléfine est supérieur ou égal à 1,3 et/ou inférieur ou égal à 20.

Selon un aspect de l'invention, le choix de la masse molaire des greffons de polyamide, pour obtenir le polymère greffé polyamide dans lequel les greffons en polyamide représente de 41% à 70% en masse dudit polymère, est fonction d'une part de la masse molaire du tronc polyoléfine et d'autre part du taux de monomère X sur ledit tronc polyoléfine.

De préférence, au moins un greffon en polyamide du polymère greffé comprend au moins un copolyamide et/ou un polyamide 6.

De préférence, le monomère insaturé X est un anhydride maléique.

Selon une possibilité offerte par l'invention, la composition polyoléfine greffé polyamide de l'invention sera diluée dans une matrice. Dans cette perspective, la composition selon l'invention comprendra alors en outre une matrice constituée par au moins une polyoléfine et/ou un polyamide, le rapport en poids de ladite matrice par rapport à la composition de polyoléfine greffé polyamide étant compris entre 9/1 et 1/9 (autrement dit la composition selon l'invention est présente dans la matrice, en poids, entre 10% et 90%), de préférence entre 4/1 et 1/4 (20% à 80%).

L'invention se rapporte également à un film comprenant la composition selon l'invention telle que décrite ci-dessus.

L'invention concerne également un film thermoplastique d'un module photovoltaïque, ledit module photovoltaïque comprenant au moins deux couches dont l'une forme la couche d'encapsulant et/ou une couche arrière de protection, caractérisé en ce que la couche d'encapsulant et/ou la couche arrière de protection comprend la composition de polyoléfine greffé polyamide telle que décrite précédemment.

Avantageusement, la couche d'encapsulant et/ou la couche arrière de protection comprend en outre une polyoléfine, le rapport en poids de ladite polyoléfine par rapport à la composition de polyoléfine greffé polyamide étant compris entre 9/1 et 1/4 (autrement dit la composition selon l'invention est présente dans la matrice, en poids, entre

10% à 80%), de préférence entre 4/1 et 1/2 (20% à 66%).

De préférence, la couche formant encapsulant comprend des promoteurs d'adhésion consistant en un ingrédient non polymérique, de nature organique, cristalline ou minéral et plus préférentiellement semi-minéral semi-organique des antioxydants et/ou des agents anti-UVs.

Il doit être noté que la composition selon l'invention est présentée avec pour application un module photovoltaïque mais bien entendu cette composition pourra être envisagée pour toutes autres applications où une telle composition est avantageusement utilisable, notamment dans les structures multicouches telles que par exemple les (dessus de) skis, les films ou revêtements adhésifs, ou les tubes de transport de fluides.

**Descriotiondes Figures annexées**

La description qui va suivre est donnée uniquement à titre illustratif et non limitatif en référence aux figures annexées, dans lesquelles :

La Figure 1, déjà décrite, représente un exemple de pile photovoltaïque, les parties (a) et (b) étant des vues de 3/4, la partie (a) montrant une cellule avant connexion et la partie (b) une vue après connexion de 2 cellules ; la partie (c) est une vue de dessus d'une pile photovoltaïque complète.

La Figure 2, déjà décrite, représente une coupe transversale d'un module photovoltaïque, dont le capteur photovoltaïque « classique » est encapsulé par un film d'encapsulant supérieur et un film d'encapsulant inférieur.

**Descriptiondétaillée de l'invention**

S'agissant de ce polymère greffé susmentionné, on utilisera entre 41 et 70%, de préférence entre 41% et 70%, en masse de greffons polyamide et un nombre de monomères (X) compris entre 1,3 et 20.

Pour obtenir la stoechiométrie entre monomère X et greffon polyamide pour un taux de polyamide compris entre 41% et 70% en poids, il faut choisir la masse molaire des greffons polyamide en fonction du taux de monomère X sur le tronc polyoléfine. Ainsi, en ajustant ces différents paramètres selon le choix de composition finale désirée, l'homme du métier peut ajuster une composition selon l'invention présentant un taux de greffons polyamide dont la masse représente entre 41% et 70% du polymère greffé polyamide.

A titre d'exemple illustratif, si l'on considère que :

- le monomère X est un anhydride maléique
- le tronc polyoléfine possède un taux massique de monomère X de 3% pour une masse molaire moyenne en nombre de 15000 g/mol, soit un nombre de monomère X par chaine de 4,6,
- que chaque greffon polyamide est porteur d'une seule fonctionnalité amine,

alors la stoechiométrie entre les fonctionnalités amines du polyamide et le monomère X est obtenue pour un taux de polyamide compris entre 41% et 70% si la masse molaire moyenne en nombre du greffon polyamide est comprise entre 2700 g/mol et 7600 g/mol.

S'agissant du tronc polyoléfine, c'est un polymère comprenant comme monomère une $\alpha$-oléfine.

On préfère les $\alpha$-oléfines ayant de 2 à 30 atomes de carbone.

A titre d'$\alpha$-oléfine, on peut citer l'éthylène, le propylène, 1-butène, 1-pentène, 3-méthyl-1-butène, 1-hexène, 4-méthyl-1-pentène, 3-méthyl-1-pentène, 1-octène, 1-décène, 1-dodécène, 1-tétradécène, 1-hexadécène, 1-octadécène, 1-eicocène, 1-dococène, 1-tétracocène, 1-hexacocène, 1-octacocène, et 1-triacontène.

On peut également citer les cyclo-oléfines ayant de 3 à 30 atomes de carbone, préférentiellement de 3 à 20 atomes de carbone, tels que le cyclopentane, le cycloheptène, le norbornène, le 5-méthyl-2-norbomène, le tétracyclododécène, et le 2-méthyl-1,4,5,8-diméthano-1,2,3,4,4a,5,8,8a-octahydronaphthalène ; di et polyoléfines, telles que la butadiène, l'isoprène, le 4-méthyl-1,3-pentadiène, le 1,4-pentadiène, 1,5-hexadiène, 1,3-hexadiène, 1,3-octadiène, 1,4-octadiène, 1,5-octadiène, 1,6-octadiène, l'éthylidènenorbomène, le vinyle norbornène, le dicyclopentadiène, le 7-méthyl-1,6-octadiène, le 4-éthylidiène-8-méthyl-1,7-nonadiène, et le 5,9-diméthyl-1,4,8-décatriène ; les composés vinyliques aromatiques tels que le mono- ou poly alkylstyrènes (comprenant le styrène, o-méthylstyrène, m-méthylstyrène, p-méthylstyrène, o,p-diméthylstyrène, o-éthylstyrène, m-éthylstyrène et p-éthylstyrène), et les dérivés comprenant des groupes fonctionnels tels que le méthoxystyrène, l'éthoxystyrène, l'acide benzoïque vinylique, le benzoate de méthyle vinyle, l'acétate de benzyle vinyle, l'hydroxystyrène, l'o-chlorostyrène, le p-chlorostyrène, le di-vinyle benzène, le 3-phénylpropène, le 4-phénylpropène, le $\alpha$-méthylstyrène, le vinyle chloride, le 1,2-difluoroéthylène, le 1,2-dichloroéthylène, le tétrafluoroéthylène, et le 3,3,3-trifluoro-1-propène.

Dans le cadre de la présente invention, le terme d'$\alpha$-oléfine comprend également le styrène. On préfère le

propylène et tout spécialement l'éthylène comme α-oléfine.

Cette polyoléfine peut-être un homopolymère lorsqu'une seule α-oléfine est polymérisée dans la chaîne polymère. On peut citer comme exemples le polyéthylène (PE) ou le polypropylène (PP).

Cette polyoléfine peut aussi être un copolymère lorsqu'au moins deux comonomères sont copolymérisés dans la chaîne polymère, l'un des deux comonomères dit le « premier comonomère » étant une α-oléfine et l'autre comonomère, dit « deuxième comonomère », est un monomère capable de polymériser avec le premier monomère.

A titre de deuxième comonomère, on peut citer :

- une des α-oléfines déjà citées, celle-ci étant différente du premier comonomère α-oléfine,
- les diènes tels que par exemple le 1,4-hexadiène, l'éthylidène norbornène, le butadiène
- les esters d'acides carboxyliques insaturés tels que par exemple les acrylates d'alkyle ou les méthacrylates d'alkyle regroupés sous le terme (méth)acrylates d'alkyles. Les chaînes alkyles de ces (méth)acrylates peuvent avoir jusqu'à 30 atomes de carbone. On peut citer comme chaînes alkyles le méthyle, l'éthyle, le propyl, n-butyl, sec-butyl, Isobutyl, tert-butyl, pentyl, hexyl, heptyl, octyl, 2-ethylhexyl, nonyl, decyl, undecyl, dodecyl, tridecyl, tetradecyl, pentadecyl, hexadecyl, heptadecyl, octadecyl, nonadecyl, eicosyl, hencosyl, docosyl, tricosyl, tetracosyl, pentacosyl, hexacosyl, heptacosyl, octacosyl, nonacosyl. On préfère les (méth)acrylates de méthyle, éthyle et butyle comme esters d'acide carboxylique insaturés.
- les esters vinyliques d'acide carboxyliques. A titre d'exemples d'esters vinyliques d'acide carboxylique, on peut citer l'acétate de vinyle, le versatate de vinyle, le propionate de vinyle, le butyrate de vinyle, ou le maléate de vinyle. On préfère l'acétate de vinyle comme ester vinylique d'acide carboxylique.

Avantageusement, le tronc en polyoléfine comprend au moins 50 % en moles du premier comonomère ; sa densité peut être avantageusement comprise entre 0,91 et 0,96.

Les troncs polyoléfines préférés sont constitués d'un copolymère éthylène-(méth)acrylate d'alkyle. En utilisant ce tronc polyoléfine, on obtient une excellente tenue au vieillissement à la lumière et à la température.

On ne sortirait pas du cadre de l'invention si différents « deuxièmes comonomères » étaient copolymérisés dans le tronc polyoléfine.

Selon la présente invention, le tronc polyoléfine contient au moins un reste de monomère insaturé (X) pouvant réagir sur une fonction acide et/ou amine du greffon polyamide par une réaction de condensation. Selon la définition de l'invention, le monomère insaturé (X) n'est pas un « deuxième comonomère ».

Comme monomère insaturé (X) compris sur le tronc polyoléfine, on peut citer :

- les époxydes insaturés. Parmi ceux-ci, ce sont par exemple les esters et éthers de glycidyle aliphatiques tels que l'allylglycidyléther, le vinylglycidyléther, le maléate et l'itaconate de glycidyle, l'acrylate et le méthacrylate de glycidyle. Ce sont aussi par exemple les esters et éthers de glycidyle alicycliques tels que le 2-cyclohexène-1-glycidyléther, le cyclohexène-4,5-diglycidylcarboxylate, le cyclohexène-4-glycidyl carboxylate, le 5-norbornène-2-méthyl-2-glycidyl carboxylate et l'endocis-bicyclo(2,2,1)-5-heptène-2,3-diglycidyl dicarboxylate. On préfère utiliser le méthacrylate de glycidyle comme époxyde insaturé.
- les acides carboxyliques insaturés et leurs sels, par exemple l'acide acrylique ou l'acide méthacrylique et les sels de ces mêmes acides.
- les anhydrides d'acide carboxylique. Ils peuvent être choisis par exemple parmi les anhydrides maléique, itaconique, citraconique, allylsuccinique, cyclohex-4-ène-1,2-dicarboxylique, 4-méthylènecyclohex-4-ène-1,2-dicarboxylique, bicyclo(2,2,1)hept-5-ène-2,3-dicarboxylique, et x-méthylbicyclo(2,2,1)hept-5-ène-2,2-dicarboxylique. On préfère utiliser l'anhydride maléique comme anhydride d'acide carboxylique.

Le monomère insaturé (X) est de préférence choisi parmi un anhydride d'acide carboxylique insaturé et un époxyde insaturé. En particulier, pour réaliser la condensation du greffon polyamide avec le tronc polyoléfine, dans le cas où l'extrémité réactive du greffon en polyamide est une fonction acide carboxylique, le monomère insaturé (X) est préférentiellement un époxyde insaturé. Dans le cas où l'extrémité réactive du greffon en polyamide est une fonction amine, le monomère insaturé (X) est avantageusement un époxyde insaturé et préférentiellement un anhydride d'acide carboxylique insaturé.

Selon une version avantageuse de l'invention, le nombre préféré de monomère insaturé (X) fixé en moyenne sur le tronc polyoléfine est supérieur ou égal à 1,3 et/ou préférentiellement inférieur ou égal à 20.

Ainsi, si (X) est l'anhydride maléique et la masse molaire en nombre de la polyoléfine est 15 000 g/mol, on a trouvé que ceci correspondait à une proportion d'anhydride d'au moins 0,8 % en masse de l'ensemble du tronc de polyoléfine et d'au plus 6,5%. Ces valeurs associées à la masse des greffons polyamide déterminent la proportion de polyamide et de tronc dans le polymère greffé polyamide.

Le tronc polyoléfine contenant le reste du monomère insaturé (X) est obtenu par polymérisation des monomères (premier comonomère, deuxième comonomère éventuel, et éventuellement monomère insaturé (X)). On peut réaliser cette polymérisation par un procédé radicalaire à haute pression ou un procédé en solution, en réacteur autoclave ou tubulaire, ces procédés et réacteurs étant bien connus de l'homme du métier. Lorsque le monomère insaturé (X) n'est pas copolymérisé dans le tronc polyoléfine, il est greffé sur le tronc polyoléfine. Le greffage est également une opération connue en soi. La composition serait conforme à l'invention si plusieurs monomères fonctionnels (X) différents étaient copolymérisés et/ou greffés sur le tronc polyoléfine.

Selon les types et ratio de monomères, le tronc polyoléfine peut être semi-cristallin ou amorphe. Dans le cas des polyoléfines amorphes, seule la température de transition vitreuse est observée, tandis que dans celui des polyoléfines semi-cristallins une température de transition vitreuse et une température de fusion (qui sera nécessairement supérieure) sont observées. Il suffira à l'homme du métier de sélectionner les ratios de monomère et les masses moléculaires du tronc polyoléfine pour pouvoir obtenir aisément les valeurs voulues de température de transition vitreuse, éventuellement de température de fusion ainsi que de viscosité du tronc polyoléfine.

De manière préférée, la polyoléfine a un Melt Flow Index (MFI) compris entre 3 et 400g/10min (190°C, 2,16kg, ASTM D 1238).

Les greffons polyamide peuvent être soit des homopolyamides, soit des copolyamides.

Sont notamment visés par l'expression "greffons polyamides" les homopolyamides aliphatiques qui résultent de la polycondensation :

- d'un lactame,
- ou d'un acide alpha, omega-aminocarboxylique aliphatique,
- ou d'une diamine aliphatique et d'un diacide aliphatique.

A titre d'exemples de lactame, on peut citer le caprolactame, l'oenantholactame et le lauryllactame.

A titre d'exemples d'acide alpha, omega-aminocarboxylique aliphatique, on peut citer l'acide aminocaproïque, l'acide amino-7-heptanoïque, l'acide amino-11-undécanoïque et l'acide amino-12-dodécanoïque.

A titre d'exemples de diamine aliphatique, on peut citer l'hexa-méthylènediamine, la dodécaméthylènediamine et la triméthylhexaméthylène diamine.

A titre d'exemples de diacide aliphatique, on peut citer les acides adipique, azélaïque, subérique, sébacique et dodécanedicarboxylique.

Parmi les homopolyamides aliphatiques, on peut citer, à titre d'exemple et de façon non limitative, les polyamides suivants : le polycaprolactame (PA6) ; le polyundécanamide (PA11, commercialisé par ARKEMA sous la marque Rilsan®) ; le polylauryllactame (PA12, également commercialisé par ARKEMA sous la marque Rilsan®) ; le polybutylène adipamide (PA4.6) ; le polyhexaméthylène adipamide (PA6.6) ; le polyhexaméthylène azélamide (PA6.9) ; le polyhexaméthylène sébaçamide (PA-6.10) ; le polyhexaméthylène dodécanamide (PA6.12) ; le polydécaméthylène dodécanamide (PA10.12) ; le polydécaméthylène sébaçanamide (PA10.10) et le polydodecaméthylène dodécanamide (PA12.12).

Sont également visés par l'expression "polyamides semi-cristallins" les homopolyamides cycloaliphatiques.

On peut notamment citer les homopolyamides cycloaliphatiques qui résultent de la condensation d'une diamine cycloaliphatique et d'un diacide aliphatique.

A titre d'exemple de diamine cycloaliphatique, on peut citer la 4,4'-méthylene-bis(cyclohexylamine), encore dénommée para-bis(aminocyclo-hexyl)méthane ou PACM, la 2,2'-diméthyl-4,4'méthylène-bis(cyclo-hexyl-amine), encore dénommée bis-(3-méthyl-4-aminocyclohexyl)-méthane ou BMACM.

Ainsi, parmi les homopolyamides cycloaliphatiques, on peut citer les polyamides PACM.12, résultant de la condensation du PACM avec le diacide en C12, les BMACM.10 et BMACM.12 résultant de la condensation de la BMACM avec, respectivement, les diacides aliphatiques en C10 et en C12.

Sont également visés par l'expression "greffons polyamide" les homopolyamides semi-aromatiques qui résultent de la condensation :

- d'une diamine aliphatique et d'un diacide aromatique, tel que l'acide téréphtalique (T) et l'acide isophtalique (I). Les polyamides obtenus sont alors couramment appelés "polyphtalamides" ou PPA ;
- d'une diamine aromatique, telle que la xylylènediamine, et plus particulièrement la métaxylylènediamine (MXD) et

d'un diacide aliphatique.

Ainsi, et de manière non limitative, on peut citer les polyamides 6.T, 6.I, MXD.6 ou encore MXD.10.

Les greffons polyamide rentrant enjeu dans la composition selon l'invention sont préférentiellement des copolyamides. Ceux-ci résultent de la polycondensation d'au moins deux des groupes de monomères énoncés ci-dessus pour l'obtention d'homopolyamides. Le terme « monomère » dans la présente description des copolyamides doit être pris au sens d' « unité répétitive ». En effet, le cas où une unité répétitive du PA est constituée de l'association d'un diacide avec une diamine est particulier. On considère que c'est l'association d'une diamine et d'un diacide, c'est-à-dire le couple diamine-diacide (en quantité équimolaire), qui correspond au monomère. Ceci s'explique par le fait qu'individuellement, le diacide ou la diamine n'est qu'une unité structurale, qui ne suffit pas à elle seule à polymériser pour donner un polyamide.

Ainsi, les copolyamides couvrent notamment les produits de condensation :

- d'au moins deux lactames,
- d'au moins deux acides alpha,omega-aminocarboxyliques aliphatiques,
- d'au moins un lactame et d'au moins un acide alpha,omega-aminocarboxylique aliphatique,
- d'au moins deux diamines et d'au moins deux diacides,
- d'au moins un lactame avec au moins une diamine et au moins un diacide,
- d'au moins un acide alpha,omega-aminocarboxylique aliphatique avec au moins une diamine et au moins un diacide,

la(les) diamine(s) et le(s) diacide(s) pouvant être, indépendamment l'un de l'autre, aliphatiques, cycloaliphatiques ou aromatiques.

Selon les types et ratio de monomères, les copolyamides peuvent être semi-cristallins ou amorphes. Dans le cas des copolyamides amorphes, seule la température de transition vitreuse est observée, tandis que dans celui des copolyamides semi-cristallins une température de transition vitreuse et une température de fusion (qui sera nécessairement supérieure) sont observées.

Parmi les copolyamides amorphes que l'on peut utiliser dans le cadre de l'invention, on peut citer par exemple les copolyamides contenant des monomères semi-aromatiques.

Parmi les copolyamides, on pourra également utiliser les copolyamides semi-cristallins et particulièrement ceux de type PA 6/11, PA6/12 et PA6/11/12.

Le degré de polymérisation peut varier dans de larges proportions, selon sa valeur c'est un polyamide ou un oligomère de polyamide.

Avantageusement, les greffons polyamide sont mono fonctionnels.

Pour que le greffon polyamide ait une terminaison monoamine, il suffit d'utiliser un limiteur de chaîne de formule :

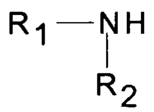

dans laquelle :

- R1 est l'hydrogène ou un groupement alkyle linéaire ou ramifié contenant jusqu'à 20 atomes de carbone,
- R2 est un groupement ayant jusqu'à 20 atomes de carbone alkyle ou alcényle linéaire ou ramifié, un radical cycloaliphatique saturé ou non, un radical aromatique ou une combinaison des précédents. Le limiteur peut être, par exemple, la laurylamine ou l'oleylamine.

Pour que le greffon polyamide ait une terminaison monoacide carboxylique, il suffit d'utiliser un limiteur de chaîne de formule R'1-COOH, R'1-CO-O-CO-R'2 ou un diacide carboxylique.

R' 1 et R'2 sont des groupements alkyles linéaires ou ramifiés contenant jusqu'à 20 atomes de carbone.

Avantageusement, le greffon polyamide possède une extrémité à fonctionnalité amine. Les limiteurs monofonctionnels de polymérisation préférés sont la laurylamine et l'oléylamine.

Les greffons polyamide ont une masse molaire comprise entre 1000 et 10000 g/mol. Etant donné que le rapport stoechiométrique pour le greffage des greffons polyamide sur le tronc polyoléfine est constant, le choix de la masse des greffons polyamide est fonction de la masse de polyamide désirée dans la composition selon ce qui a été expliqué précédemment.

Le greffage du polyamide sur le tronc polyoléfine se fait par l'intermédiaire de la réaction entre le monomère X du tronc polyoléfine et la fonctionnalité Y portée à l'une, et une seule, des extrémités du polyamide. Si le nombre de fonctionnalités Y est supérieur au nombre de monomères X alors une partie des greffons polyamide sera, de fait, non greffée. La stoechiométrie entre monomères X et fonctionnalités Y dépend du taux de monomère X porté par le tronc polyoléfine, du taux de polyamide par rapport au tronc polyoléfine et de la masse molaire du greffon polyamide. Les nombres de mole en monomère X et fonctionnalité Y, $n_X$ et $n_Y$, sont donnés par :

$n_X = \frac{x_X . x_{PO}}{M_X}$ avec $x_x$, $x_{PO}$ et $M_x$ respectivement la fraction massique de monomère X dans le tronc polyoléfine, $x_{PO}$ la fraction massique de tronc polyoléfine dans le mélange et $M_x$ la masse molaire du monomère X.

$n_Y = \frac{x_{PA}}{M_{PA}}$ avec $x_{PA}$ et $M_{PA}$ respectivement la fraction massique de polyamide dans le mélange et $M_{PA}$ la masse molaire moyenne en nombre du polyamide.

La stoechiométrie donne $n_X = n_Y$. Si on veut que cette condition soit vérifiée pour un taux massique en polyamide compris entre 45% et 70%, la masse molaire du greffon doit être choisie en conséquence. En choisissant le tronc polyoléfine, $M_X$ et $x_X$ sont fixés, $x_{PA}$ étant compris entre 45% et 70, la masse molaire du greffon polyamide est donnée par la relation $M_{PA} = \frac{M_X . x_{PA}}{x_X .(1 - x_{PA})}$.

La polycondensation définie ci-dessus s'effectue selon les procédés habituellement connus, par exemple à une température comprise en général entre 200 et 300°C, sous vide ou sous atmosphère inerte, avec agitation du mélange réactionnel. La longueur de chaîne moyenne du greffon est déterminée par le rapport molaire initial entre le monomère polycondensable ou le lactame et le limiteur monofonctionnel de polymérisation. Pour le calcul de la longueur de chaîne moyenne, on compte habituellement une molécule de limiteur de chaîne pour une chaîne de greffon.

Il suffira à l'homme du métier de sélectionner les types et ratio de monomères ainsi que choisir les masses molaires des greffons polyamide pour pouvoir obtenir aisément les valeurs voulues de température de transition vitreuse, éventuellement de température de fusion ainsi que de viscosité du greffon polyamide.

La réaction de condensation du greffon polyamide sur le tronc de polyoléfine contenant le reste de X s'effectue par réaction d'une fonction amine ou acide du greffon polyamide sur le reste de X. Avantageusement, on utilise des greffons polyamide monoamine et on crée des liaisons amides ou imides en faisant réagir la fonction amine sur la fonction du reste de X.

On réalise cette condensation de préférence à l'état fondu. Pour fabriquer la composition selon l'invention, on peut utiliser les techniques classiques de malaxage et/ou d'extrusion. Les composants de la composition sont ainsi mélangés pour former un compound qui pourra éventuellement être granulé en sortie de filière. Avantageusement, des agents de couplage sont ajoutés lors du compoundage.

Pour obtenir une composition nanostructurée, on peut ainsi mélanger le greffon polyamide et le tronc dans une extrudeuse, à une température généralement comprise entre 200 et 300 °C. Le temps de séjour moyen de la matière fondue dans l'extrudeuse peut être compris entre 5 secondes et 5 minutes, et de préférence entre 20 secondes et 1 minute. Le rendement de cette réaction de condensation est évalué par extraction sélective des greffons de polyamide libres, c'est-à-dire ceux qui n'ont pas réagi pour former le polymère greffé polyamide.

La préparation de greffons polyamide à extrémité amine ainsi que leur addition sur un tronc de polyoléfine contenant le reste de (X) est décrite dans les brevets US3976720, US3963799, US5342886 et FR2291225. Le polymère greffé polyamide de la présente invention présente avantageusement une organisation nanostructurée.

La composition selon l'invention peut être éventuellement diluée pour être incorporée dans une matrice. Il a été noté par la demanderesse que, de façon surprenante, la dilution d'un composé polyoléfine fortement greffé polyamide dans une matrice polyoléfine présente des résultats, en particulier sur le plan mécanique, bien plus satisfaisant qu'un composé polyoléfine bien moins fortement greffé polyamide (< 45%) mais moins dilué dans une matrice polyoléfine et/ou polyamide de sorte qu'au final, dans les deux matrices (dans lesquelles sont dilués respectivement les deux composés polyoléfine greffé polyamide), la quantité de polyamide est strictement identique.

A titre d'exemple non limitatif, on a choisi d'illustrer ces propriétés inattendues obtenues lors de la dilution d'une composition selon l'invention dans une matrice polyoléfine dans le cas d'un module photovoltaïque.

Néanmoins, il doit être noté que la composition selon l'invention pourra également être présente dans une

matrice à base polyamide. Enfin, la dilution de la composition selon l'invention pourra s'effectuer dans une matrice comportant à la fois une ou plusieurs polyoléfine(s) et un ou plusieurs polyamide(s). On notera que, selon une possibilité offerte par l'invention, la polyoléfine formant la matrice peut être porteuse d'une fonction réactive vis-à-vis du greffon polyamide.

On utilise ici le terme « matrice » pour désigner les composants dans lesquels la composition polyoléfine greffé polyamide selon l'invention est diluée lorsque lesdits composants représentent au moins 50% en poids du mélange. Par extension, on conserve le terme de « matrice » lorsque les composants [polyoléfine(s) et/ou polyamide(s)] sont présents dans une quantité, en poids, inférieure à 50% du mélange mais il est entendu que le terme de « matrice » présente alors plutôt la fonction de diluant.

Ainsi, la composition selon l'invention est diluée dans une polyoléfine pour être incorporée notamment à une couche d'encapsulant ou à la face arrière (backsheet) d'un module photovoltaïque.

La dilution de la composition selon l'invention est particulièrement intéressante.

Des tests ont été réalisés en utilisant les éprouvettes suivantes :

Composition Apolhya® exemple 1 : composition d'une polyoléfine greffée polyamide à 20% de greffon polyamide. La polyoléfine fonctionnalisée est le Lotader® 7500 de la société Arkema France. Le greffon polyamide est caractérisé par une masse molaire moyenne en nombre de 2500 g/mol et par une température de fusion de 130°C.

Composition Apolhya® exemple 2: Composition d'une polyoléfine greffée polyamide à 50%de greffons polyamide. La polyoléfine fonctionnalisée est le Lotader® 7500. Le greffon polyamide est caractérisé par une masse molaire moyenne de 2500 g/mol et par une température de fusion de 130°C.

Les deux compositions Apolhya® exemples 1 et 2 ci-dessus ont été obtenues sur une extrudeuse bi-vis de type Werner® 30.

Deux films sont extrudés sur une extrudeuse mono-vis de chez Thoret® :

- un film de 400 $\mu$m (micromètre) de l'exemple 1 ci-dessus
- un film de 400 $\mu$m d'une composition comprenant 20% de greffon polyamide fabriqué en diluant la composition de l'exemple 2 ci-dessus dans le Lotader 7500 dans des proportions 60% en masse de Lotader 7500 pour 40% en masse de l'exemple 2 ci-dessus.

Des éprouvettes de type IFC (Institut Français du Caoutchouc) sont découpées à l'emporte-pièce dans les films. Une contrainte de 0,5 bars est appliquée en suspendant un poids à une extrémité de l'éprouvette. L'éprouvette est placée pendant 15 minutes à 100°C. La déformation résiduelle est mesurée après retour à l'ambiante.

Les résultats du test de fluage sont présentés dans le tableau ci-dessous :

| | Eprouvette Apolhya exemple 1 | Eprouvette Apolhya exemple 2/Lotader 7500 rapport 40/60 |
|---|---|---|
| déformation résiduelle | 20% | 8% |

Lorsque la composition selon l'invention est utilisée dans la couche d'encapsulant ou de la face arrière (backsheet) d'un module photovoltaïque, la composition est de préférence diluée et comporte également un certain nombre d'additifs.

Des plastifiants pourront être ajoutés à la couche formant l'encapsulant afin de faciliter la mise en oeuvre et améliorer la productivité du procédé de fabrication de la composition et des structures. On citera comme exemples les huiles minérales paraffiniques aromatiques ou naphtaléniques qui permettent également d'améliorer le pouvoir d'adhérence de la composition selon l'invention. On peut également citer comme plastifiant les phtalates, azelates, adipates, le phosphate de ticrésyle.

De la même manière, des promoteurs d'adhésion, bien que non nécessaires, peuvent être avantageusement ajoutés afin d'améliorer le pouvoir d'adhérence de la composition lorsque celui-ci doit être particulièrement élevé. Le promoteur d'adhésion est un ingrédient non polymérique ; il peut être organique, cristallin, minéral et plus préférentiellement semi-minéral semi-organique. Parmi ceux-ci, on peut citer les titanates ou les silanes organiques, comme par exemple les monoalkyl titanates, les trichlorosilanes et les trialkoxysilanes, les trialcooxysilane. Avantageusement, on utilisera les trialcooxysilanes contenant un groupement époxy, vinyle et amine en particulier dans le cas où ces promoteurs d'adhésion sont prévus en tant que mélange maître avec l'encapsulant-backsheet selon l'invention. On pourra également prévoir que ces promoteurs d'adhésion sont directement greffés sur la polyoléfine de la couche formant encapsulant

par une technique bien connue de l'homme du métier, par exemple l'extrusion réactive.

Le rayonnement UV étant susceptible d'entraîner un léger jaunissement de la composition utilisée en tant qu'encapsulant desdits modules, des stabilisants UV et des absorbeurs UV (ces composés étant dénommés de manière générale des agents anti-UVs) tels que le benzotriazole, le benzophénone et les autres amines encombrés, peuvent être ajoutés afin d'assurer la transparence de l'encapsulant durant sa durée de vie. Ces composés peuvent être par exemple à base de benzophénone ou de benzotriazole. On peut les ajouter dans des quantités inférieures à 10% en masse de la masse totale de la composition et préférentiellement de 0,1 à 5%.

On pourra également ajouter des anti-oxydants pour limiter le jaunissement lors de la fabrication de l'encapsulant tels que les composés phosphorés (phosphonites et/ou phosphites) et les phénoliques encombrés. On peut ajouter ces anti-oxydants dans des quantités inférieures à 10% en masse de la masse totale de la composition et préférentiellement de 0,1 à 5%.

De la même manière, des agents retardateurs de flamme peuvent également être ajoutés à la couche encapsulant ainsi qu'à la couche formant le backsheet (décrite ci-dessous). Ces agents peuvent être halogénés ou non-halogénés. Parmi les agents halogénés, on peut citer les produits bromés. On peut également utiliser comme agent non-halogéné les additifs à base de phosphore tels que le phosphate d'ammonium, de polyphosphate, de phosphinate ou de pyrophosphate, le cyanurate de mélamine, le pentaérythritol, les zéolithes ainsi que les mélanges de ces agents. La composition peut comprendre ces agents dans des proportions allant de 3 à 40% par rapport à la masse totale de la composition. On pourra également ajouter des composés colorants ou azurants.

On peut également ajouter à la couche encapsulant des pigments comme par exemple des composés colorants ou azurants dans des proportions allant généralement de 5 à 15% par rapport à la masse totale de la composition.

<u>Préparation de la composition selon l'invention :</u>

La technique de greffage des greffons polyamide sur le tronc polyoléfine pour obtenir la polyoléfine greffé polyamide selon l'invention est bien connu de l'homme du métier, et notamment des documents cités précédemment FR 2912150, FR 2918150 ou EP 21966489.

On ne sort donc pas du cadre de l'invention si des agents réticulant sont ajoutés. On peut citer comme exemples des isocyanates ou des peroxydes organiques. Cette réticulation peut également être réalisée par des techniques connues d'irradiation. Cette réticulation peut être effectuée par l'une des nombreuses méthodes connues de l'homme du métier, notamment par l'utilisation d'initiateurs activés thermiquement, par exemple des composés peroxydes et azo, des photoinitiateurs tels que le benzophénone, par des techniques de radiation comportant des rayons lumineux, des rayons UV, des faisceaux d'électrons et des rayons X, de silanes porteurs de fonctions réactives comme un amino silane, un époxy silane, un vinyle silane tel que par exemple le vinyle silane tri-éthoxy ou tri-méthoxy, et de la réticulation par voie humide. Le manuel intitulé « Handbook of polymer foams and technology » supra, aux pages 198 à 204, fournit des enseignements complémentaires auxquels l'homme du métier peut se référer.

Concernant les aspects de l'invention relatifs à l'utilisation de la composition thermoplastique dans un module photovoltaïque, l'Homme de l'Art peut se référer par exemple au Handbook of Photovoltaic Science and Engineering, Wiley, 2003. En effet, la composition de l'invention peut être utilisée en tant qu'encapsulant ou encapsulant-backsheet dans un module photovoltaïque, dont on décrit la structure en relation avec les figures annexées.

**<u>Matériaux employés pour former les formulations testées:</u>**

**Lotader® 7500:** terpolymère d'éthylène, d'acrylate d'éthyle (17,5 % en poids) et d'anhydride maléique (2,8 % en poids) produit par ARKEMA possédant un MFI (190°C sous 2,16 kg mesuré selon ISO 1133) de 70g/10mn

**Lotader® 4210:** terpolymère d'éthylène, d'acrylate de butyle (6,5 % en poids) et d'anhydride maléique (3,6 % en poids) produit par ARKEMA possédant un MFI (190°C sous 2,16 kg mesuré selon ISO 1133) de 9g/10mn

**Lotader® 6200:** terpolymère d'éthylène, d'acrylate d'éthyle (6,5 % en poids) et d'anhydride maléique (2,8 % en poids) produit par ARKEMA possédant un MFI (190°C sous 2,16 kg mesuré selon ISO 1133) de 40g/10mn

**Prépolymère PA6 :** Deux prépolymères PA6 ont été synthétisés par polycondensation à partir du lactame 6. La laurylamine est utilisée comme limitateur de chaîne de façon à avoir une seule fonctionnalité amine primaire en bout de chaîne. La masse molaire moyenne en nombre du premier prépolymère est de 2500 g/mol, celle du deuxième de 4000 g/mol.

**Prépolymère copolyamide à température de fusion 130°C** : 1 prépolymère copolyamide 6/12 a été synthétisé par polycondensation à partir du lactame 6 et du lactame 12. Le ratio lactame 6/lactame 12 est ajusté pour obtenir une température de fusion de 130°C. La laurylamine est utilisée comme limitateur de chaîne de façon à avoir une seule fonctionnalité amine primaire en bout de chaîne. Sa masse molaire moyenne en nombre est de 2500 g/mol.

**Apolhya®:** La famille Apolhya est une famille de polymères commercialisée par ARKEMA qui allient les propriétés des polyamides à celles des polyoléfines grâce à l'obtention de morphologies co-continues à l'échelle manométrique. Dans le cadre des tests, il est retenu plusieurs types d'Apolhya® :

- une famille d'Apolhya® présentant respectivement 10%, 20%, 30%, 40%, 45%, 50%, 55%, 60%, 65%, 70% sur la base du Lotader® 7500 et du copolyamide 6/12 (utilisés pour le test de Haze).
- une famille d'Apolhya® présentant respectivement 10%, 20%, 30%, 40%, 45%, 50%, 55%, 62.5%, 70% sur la base du Lotader® 4210 et du prépolymère PA6 de masse molaire 2500 g/mol (utilisés pour le test MFI).
- une famille d'Apolhya® présentant respectivement 10%, 20%, 30%, 40%, 45%, 50%, 60%, 70% sur la base du Lotader® 6200 et du prépolymère PA6 de masse molaire 2500 g/mol (utilisés pour le test MFI).
- une famille d'Apolhya® présentant respectivement 10%, 20%, 30%, 40%, 45%, 50%, 55%, 62.5%, 70% sur la base du Lotader® 4210 et du prépolymère PA6 de masse molaire 4000 g/mol (utilisés pour le test MFI).

**Obterition des formulations et films testés** :

- Extrusion réactive des formulations Apolhya

  ◦ Extrusion réactive des formulations sur base Lotader 7500 et copolyamide 6/12
  Ces formulations Apolhya® ont été préparées par « compoundage » grâce à une extrudeuse double vis co-rotative de type ZSK 30 de COPERION Werner et Pfleiderer® dont les éléments de fourreaux sont chauffés selon un profil plat à 200°C ; la vitesse de rotation est de 300 rpm (« round per minute » ou Tour Par Minute) avec un débit de 25 kg/h (kilogramme par heure).
  ◦ Extrusion réactive des formulations Apolhya sur base Lotader 4210 et polyamide 6
  Ces formulations Apolhya® ont été préparées par compoundage grâce à une petite extrudeuse double vis co-rotative de laboratoire de type Haake 2. Les éléments de fourreaux sont chauffés selon un profil plat à 240°C ; la vitesse de rotation des vis est de 300 rpm.

- Extrusion d'un film monocouche de 400μm d'Apolhya ou de Lotader

  ◦ Extrusion réactive des formulations sur base Lotader 7500 et copolyamide 6/12
  Des films monocouches de 400μm (micromètre) ont été réalisés par extrusion de film à plat (CAST) sur une ligne d'extrusion de marque Dr COLLIN®. Cette ligne d'extrusion se compose de trois extrudeuses équipées d'un profil de vis standard polyoléfine, d'un bloc de coextrusion variable (variable « feedblock »), et d'une filière porte manteaux de 250 mm (« coat hanger die »).
  Les paramètres procédés suivants ont été utilisés pour l'extrusion du film monocouche de 400 μm d'Apolhya, quelque soit son taux de polyamide, ainsi que pour le Lotader :

  - T° extrusion et 150°C (degré Celsius),
  - T° (température) de la boite de coextrusion et filière : 160°C,
  - la vitesse de ligne est de 2,6 m/min (mètre par minute).

  o Extrusion réactive des formulations sur base Lotader 4210 et polyamide 6
  Des films monocouches de 400μm (micromètre) ont été réalisés par extrusion de film à plat sur une petite ligne d'extrusion de laboratoire. Il s'agit d'une bi-vis contrarotative de type Haake 1 équipée d'une filière plate de 10 cm (centimètre) de large et de 0,5 mm (millimètre) d'ouverture. Les éléments de fourreaux sont chauffés selon un profil plat à 210°C ; la vitesse de rotation des vis est de 60 rpm.

**Tests réalisés sur les films :**

Test du « Melt Flow Index »:

L'indice de fluidité ou « Melt flow index » a été mesuré à l'aide d'un Plastomètre Gôttfert MI3 selon la norme ISO 1133. Le MFI des Apolhya® à base de prépolymère PA6 a été mesuré sous une masse de 2.16 kg à 230°C, celui des Lotader® et des Apolhya® à base de copolyamide 6/12 sous une masse de 2.16 kg et 190°C.

Résultats de melt flow index pour les formulations à base de Lotader 6200 et prépolymère PA6

| % de polyamide de masse molaire 2500 g/mol | MFI |
|---|---|
| 0 | 40 (190°C) |
| 10 | 19 |
| 20 | 9 |
| 30 | 1 |
| 40 | 3 |
| 45 | 6 |
| 50 | 25 |
| 60 | 50 |
| 70 | 90 |

Ces résultats montrent que, contrairement à ce qui pouvait être envisagé, le MFI des compositions au-delà de 40% de polyamide greffé ne diminue plus au-delà, voire augmente. Ceci rend la composition industrialisable sans aucune difficulté.

Résultats de melt flow index pour les formulations à base de Lotader 4210 et prépolymère PA6

| % de polyamide de masse molaire 2500 g/mol | MFI | % de polyamide de masse molaire 4000 g/mol | MFI |
|---|---|---|---|
| 0 | 9 (190°C) | 0 | 9 (190°C) |
| 10 | 15 | 10 | 20 |
| 20 | 4 | 20 | 8 |
| 30 | 2 | 30 | 4 |
| 40 | 1 | 40 | 2 |
| 45 | 5 | 45 | 7 |
| 50 | 10 | 50 | 15 |
| 62,5 | 25 | 50 | 15 |
| 70 | 50 | 70 | 95 |

Ces résultats montrent que, contrairement à ce qui pouvait être envisagé, le MFI des compositions au-delà de 40% de polyamide greffé ne diminue plus au-delà, voire augmente. Ceci rend la composition industrialisable sans aucune difficulté.

Test de Haze :

Les résultats pour toutes les éprouvettes sont présentés dans le tableau ci-dessous :

| | Transmittance dans le visible (ep 400 $\mu$m) | Haze (%) |
|---|---|---|
| Lotader | 95 | 9 |
| Apolhya à 10% de taux massique de greffage PA | 96.0 | 6 |
| Apolhya à 20% de taux massique de greffage PA | 96.5 | 3 |
| Apolhya à 30% de taux massique de greffage PA | 96.5 | 3 |
| Apolhya à 40% de taux massique de greffage PA | 96.5 | 3 |
| Apolhya à 45% de taux massique de greffage PA | 96 | 3 |

(suite)

| | Transmittance dans le visible (ep 400 μm) | Haze (%) |
|---|---|---|
| Apolhya à 50% de taux massique de greffage PA | 96 | 3 |
| Apolhya à 55% de taux massique de greffage PA | 96 | 3 |
| Apolhya à 60% de taux massique de greffage PA | 95.5 | 3 |
| Apolhya à 65% de taux massique de greffage PA | 95.0 | 5 |
| Apolhya à 70% de taux massique de greffage PA | 94 | 8 |

Ces résultats, obtenus à partir des formulations Apolhya base du Lotader® 7500 et du copolyamide 6/12, montrent clairement, et contrairement à nouveau à ce qui pouvait être attendu de façon théorique et empirique, que les films de compositions à fort taux massique de polyamide greffé sont au moins aussi transparents que ceux à faible taux de polyamide greffé.

## Revendications

**1.** Composition thermoplastique comprenant un tronc en polyoléfine contenant un reste d'au moins un monomère insaturé (X) et une pluralité de greffons en polyamide, dans lequel :

- les greffons en polyamide sont attachés au tronc en polyoléfine par le reste du monomère insaturé (X) comprenant une fonction capable de réagir par une réaction de condensation avec un polyamide ayant au moins une extrémité amine et/ou au moins une extrémité acide carboxylique,
- le reste du monomère insaturé (X) est fixé sur le tronc par greffage ou copolymérisation,

**caractérisé en ce que** les greffons en polyamide représente de 41% à 70%, de préférence de 45% à 70%, en masse dudit polymère greffé polyamide.

**2.** Composition selon la revendication 1, **caractérisée en ce que** le susdit polymère greffé est nanostructuré.

**3.** Composition selon la revendication 1 ou 2, **caractérisée en ce que** la masse molaire en nombre des susdits greffons polyamide du susdit polymère greffé est comprise dans la gamme allant de 1000 à 10000 g/mol.

**4.** Composition selon l'une quelconque des revendications précédentes, **caractérisée en ce que**, pour les susdits polymères greffés, le nombre de monomère (X) fixé sur le tronc en polyoléfine est supérieur ou égal à 1,3 et/ou inférieur ou égal à 20.

**5.** Composition selon l'une quelconque des revendications précédentes, **caractérisée en ce que** le choix de la masse molaire des greffons de polyamide, pour obtenir le polymère greffé polyamide dans lequel les greffons en polyamide représente de 41% à 70% en masse dudit polymère, est fonction d'une part de la masse molaire du tronc polyoléfine et d'autre part du taux de monomère X sur ledit tronc polyoléfine.

**6.** Composition selon l'une quelconque des revendications précédentes, **caractérisée en ce qu'**au moins un greffon en polyamide du polymère greffé comprend au moins un copolyamide ou un polyamide 6.

**7.** Composition selon l'une quelconque des revendications précédentes, **caractérisée en ce que** le monomère insaturé (X) est un anhydride maléique.

**8.** Composition selon l'une quelconque des revendications précédentes, **caractérisée en ce qu'**elle comprend en outre une matrice constituée par au moins une polyoléfine et/ou un polyamide, le rapport en poids de ladite matrice par rapport à la composition de polyoléfine greffé polyamide étant compris entre 9/1 et 1/9 et, de préférence entre 4/1 et 1/4.

**9.** Film thermoplastique comprenant la composition selon l'une quelconque des revendications précédentes.

**10.** Film thermoplastique d'un module photovoltaïque, ledit module photovoltaïque comprenant au moins deux couches dont l'une forme la couche d'encapsulant et/ou une couche arrière de protection, **caractérisé en ce que** la couche d'encapsulant et/ou la couche arrière de protection comprend la composition de polyoléfine greffé polyamide selon l'une quelconque des revendications 1 à 7.

**11.** Film selon la revendication 10, **caractérisé en ce que** la couche d'encapsulant et/ou la couche arrière de protection comprend en outre une polyoléfine, le rapport en poids de ladite polyoléfine par rapport à la composition de polyoléfine greffé polyamide étant compris entre 9/1 et 1/4, de préférence entre 4/1 et 1/2.

**12.** Film selon la revendication 10 ou 11, **caractérisé en ce que** la couche formant encapsulant comprend des promoteurs d'adhésion consistant en un ingrédient non polymérique, de nature organique, cristalline ou minéral et plus préférentiellement semi-minéral semi-organique, des antioxydants et/ou des agents anti-UVs.

## Patentansprüche

**1.** Thermoplastische Zusammensetzung, umfassend eine Polyolefin-Hauptkette, die einen Rest mindestens eines ungesättigten Monomers (X) enthält, und mehrere Polyamid-Pfropfanteile, wobei:

- die Polyamid-Pfropfanteile über den Rest des ungesättigten Monomers (X) mit einer Funktion, die durch eine Kondensationsreaktion mit einem Polyamid mit mindestens einer Aminendgruppe und/oder mindestens einer Carbonsäureendgruppe reagieren kann, an die Polyolefin-Hauptkette gebunden sind,
- der Rest des ungesättigten Monomers (X) durch Pfropfung oder Copolymerisation an der Hauptkette fixiert ist,

**dadurch gekennzeichnet, dass** die Polyamid-Pfropfanteile 41 bis 70 Gew.-%, vorzugsweise 45 bis 70 Gew.-%, des Polyamid-Pfropfpolymers ausmachen.

**2.** Zusammensetzung nach Anspruch 1, **dadurch gekennzeichnet, dass** das Pfropfpolymer nanostrukturiert ist.

**3.** Zusammensetzung nach Anspruch 1 oder 2, **dadurch gekennzeichnet, dass** das zahlenmittlere Molekulargewicht der Polyamid-Pfropfanteile des Pfropfpolymers im Bereich von 1000 bis 10.000 g/mol liegt.

**4.** Zusammensetzung nach einem der vorhergehenden Ansprüche, **dadurch gekennzeichnet, dass** für die Pfropfpolymere die Zahl der an der Polyolefin-Hauptkette fixierten Monomere (X) größer gleich 1,3 und/oder kleiner gleich 20 ist.

**5.** Zusammensetzung nach einem der vorhergehenden Ansprüche, **dadurch gekennzeichnet, dass** die Wahl des Molekulargewichts der Polyamid-Pfropfanteile zum Erhalt des Polyamid-Pfropfpolymers, in dem die Polyamid-Pfropfanteile 41 bis 70 Gew.-% des Polymers ausmachen, einerseits vom Molekulargewicht der Polyolefin-Hauptkette und andererseits vom Monomer-X-Gehalt der Polyolefin-Hauptkette abhängt.

**6.** Zusammensetzung nach einem der vorhergehenden Ansprüche, **dadurch gekennzeichnet, dass** mindestens ein Polyamid-Pfropfanteil des Pfropfpolymers mindestens ein Copolyamid oder ein Polyamid 6 umfasst.

**7.** Zusammensetzung nach einem der vorhergehenden Ansprüche, **dadurch gekennzeichnet, dass** es sich bei dem ungesättigten Monomer (X) um Maleinsäureanhydrid handelt.

**8.** Zusammensetzung nach einem der vorhergehenden Ansprüche, **dadurch gekennzeichnet, dass** sie außerdem eine Matrix umfasst, die aus mindestens einem Polyolefin und/oder einem Polyamid besteht, wobei das Gewichtsverhältnis von Matrix zu Zusammensetzung von polyamidgepfropftem Polyolefin zwischen 9/1 und 1/9 und vorzugsweise zwischen 4/1 und 1/4 liegt.

**9.** Thermoplastische Folie, umfassend die Zusammensetzung nach einem der vorhergehenden Ansprüche.

**10.** Thermoplastische Folie eines Photovoltaikmoduls, wobei das Photovoltaikmodul mindestens zwei Schichten umfasst, von denen eine die Verkapselungsschicht und/oder eine Rückseitenschutzschicht bildet, **dadurch gekennzeichnet, dass** die Verkapselungsschicht und/oder die Rückseitenschutzschicht die Zusammensetzung von polyamidgepfropftem Polyolefin nach einem der Ansprüche 1 bis 7 umfasst.

11. Folie nach Anspruch 10, **dadurch gekennzeichnet, dass** die Verkapselungsschicht und/oder die Rückseitenschutzschicht außerdem ein Polyolefin umfasst, wobei das Gewichtsverhältnis von Polyolefin zu Zusammensetzung von polyamidgepfropftem Polyolefin zwischen 9/1 und 1/4 und vorzugsweise zwischen 4/1 und 1/2 liegt.

12. Folie nach Anspruch 10 oder 11, **dadurch gekennzeichnet, dass** die ein Verkapselungsmittel bildende Schicht Haftvermittler, die aus einem nicht polymeren Bestandteil organischer, kristalliner oder mineralischer Beschaffenheit und weiter bevorzugt halbmineralischer halborganischer Beschaffenheit bestehen, Antioxidantien und/oder Anti-UV-Mittel umfasst.

## Claims

1. A thermoplastic composition comprising a polyolefin backbone comprising a residue of at least one unsaturated monomer (X) and a plurality of polyamide grafts, in which:

   - the polyamide grafts are attached to the polyolefin backbone by the residue of the unsaturated monomer (X) comprising a functional group capable of reacting by a condensation reaction with a polyamide having at least one amine end and/or at least one carboxylic acid end,
   - the residue of the unsaturated monomer (X) is attached to the backbone by grafting or copolymerization,

   **characterized in that** the polyamide grafts represent from 41% to 70%, preferably from 45% to 70%, by mass of said polyamide-grafted polymer.

2. The composition as claimed in claim 1, **characterized in that** the abovesaid grafted polymer is nanostructured.

3. The composition as claimed in claim 1 or 2, **characterized in that** the number-average molar mass of the abovesaid polyamide grafts of the abovesaid grafted polymer is within the range extending from 1000 to 10 000 g/mol.

4. The composition as claimed in any one of the preceding claims, **characterized in that**, for the abovesaid grafted polymers, the number of monomers (X) attached to the polyolefin backbone is greater than or equal to 1.3 and/or less than or equal to 20.

5. The composition as claimed in any one of the preceding claims, **characterized in that** the choice of the molar mass of the polyamide grafts, in order to obtain the polyamide-grafted polymer in which the polyamide grafts represent from 41% to 70% by mass of said polymer, depends on the one hand, on the molar mass of the polyolefin backbone and, on the other hand, on the content of monomers X on said polyolefin backbone.

6. The composition as claimed in any one of the preceding claims, **characterized in that** at least one polyamide graft of the grafted polymer comprises at least one copolyamide or one polyamide 6.

7. The composition as claimed in any one of the preceding claims, **characterized in that** the unsaturated monomer (X) is a maleic anhydride.

8. The composition as claimed in any one of the preceding claims, **characterized in that** it additionally comprises a matrix composed of at least one polyolefin and/or one polyamide, the ratio by mass of said matrix with respect to the polyamide-grafted polyolefin composition being between 9/1 and 1/9 and preferably between 4/1 and 1/4.

9. A thermoplastic film comprising the composition as claimed in any one of the preceding claims.

10. A thermoplastic film of a photovoltaic module, said photovoltaic module comprising at least two layers, one of which forms the encapsulant layer and/or a back protective layer, **characterized in that** the encapsulant layer and/or the back protective layer comprises the polyamide-grafted polyolefin composition as claimed in any one of claims 1 to 7.

11. The film as claimed in claim 10, **characterized in that** the encapsulant layer and/or the back protective layer additionally comprises a polyolefin, the ratio by mass of said polyolefin with respect to the polyamide-grafted polyolefin composition being between 9/1 and 1/4, preferably between 4/1 and 1/2.

12. The film as claimed in claim 10 or 11, **characterized in that** the encapsulant-forming layer comprises adhesion

promoters, consisting of a nonpolymeric ingredient, of organic, crystalline or mineral nature and more preferably semi-mineral semi-organic nature, antioxidants and/or UV inhibitors.

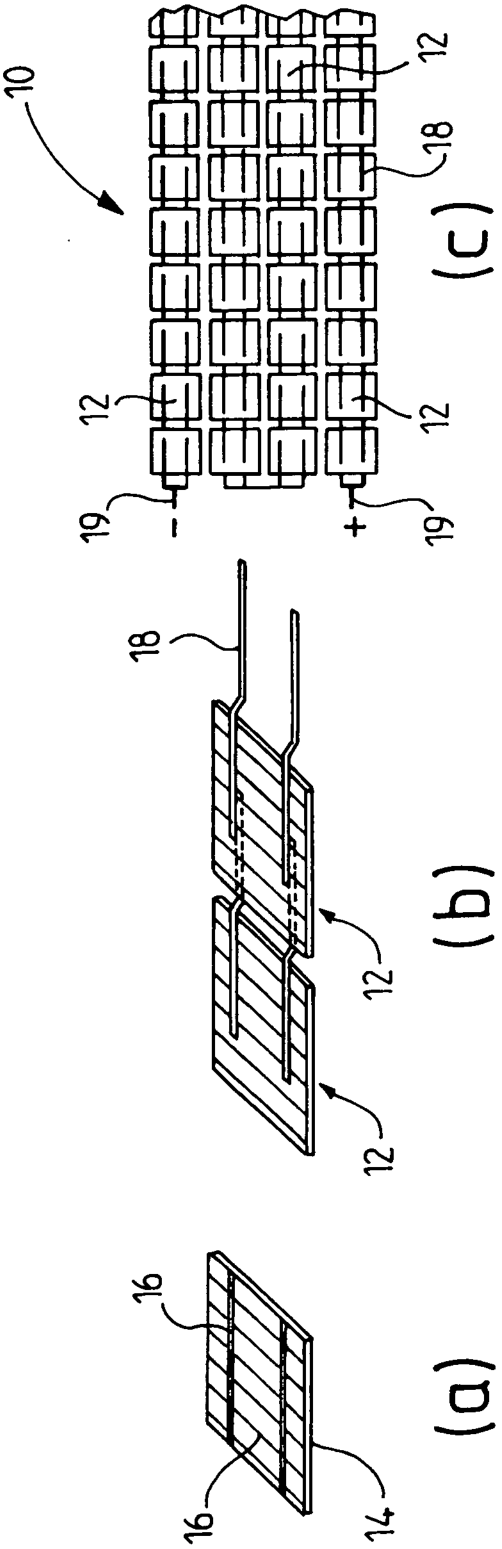


FIG.1

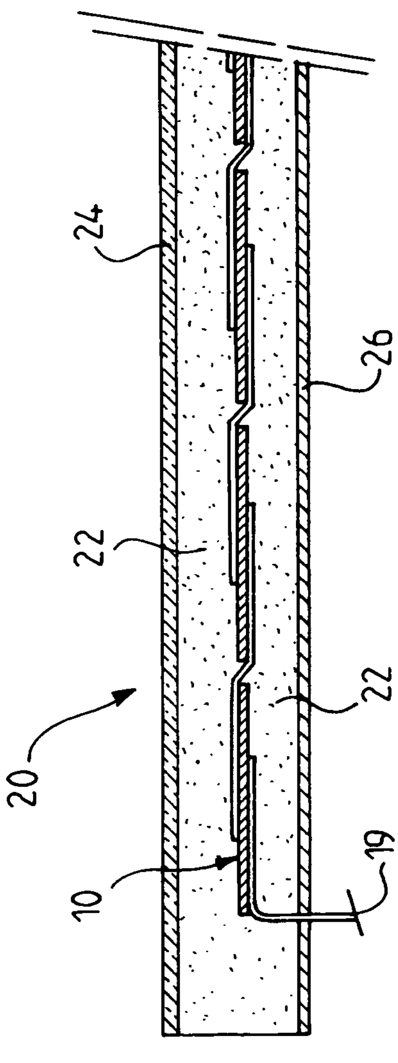


FIG.2

## RÉFÉRENCES CITÉES DANS LA DESCRIPTION

*Cette liste de références citées par le demandeur vise uniquement à aider le lecteur et ne fait pas partie du document de brevet européen. Même si le plus grand soin a été accordé à sa conception, des erreurs ou des omissions ne peuvent être exclues et l'OEB décline toute responsabilité à cet égard.*

### Documents brevets cités dans la description


- FR 2918150
- EP 2196489 A
- US 3976720 A
- US 3963799 A
- US 5342886 A
- FR 2291225
- FR 2912150
- EP 21966489 A


### Littérature non-brevet citée dans la description


- Handbook of Photovoltaic Science and Engineering. Wiley, 2003